Europäisches Patentamt

European Patent Office

Office européen des brevets

(11) Numéro de publication: **0 192 541**
**A1**

## (12) DEMANDE DE BREVET EUROPEEN

(21) Numéro de dépôt: 86400236.5

(22) Date de dépôt: 04.02.86

(51) Int. Cl.⁴: **H01L 23/42**

(30) Priorité: 08.02.85 FR 8501819

(43) Date de publication de la demande:
27.08.86 Bulletin 86/35

(84) Etats contractants désignés:
AT BE CH DE GB IT LI LU NL SE

(71) Demandeur: CIMSA SINTRA
26, rue Malakoff
F-92600 - ASNIERES(FR)

(72) Inventeur: **Tatareau, Pierre**
**THOMSON-CSF SCPI 19, avenue de Messine**
**F-75008 Paris(FR)**
Inventeur: **Ravoire, François-Daniel**
**THOMSON-CSF SCPI 19, avenue de Messine**
**F-75008 Paris(FR)**

(74) Mandataire: **Lincot, Georges et al**
**THOMSON-CSF SCPI 19, avenue de Messine**
**F-75008 Paris(FR)**

(54) **Dispositif de refroidissement de circuits intégrés à semiconducteur.**

(57) Le dispositif de refroidissement de circuits intégrés à semiconducteur selon l'invention établit un pont thermique entre chaque circuit intégré (1) à refroidir et une enceinte étanche à l'aide d'un dispositif caloduc composé d'un réservoir d'évaporation (9) placé en contact thermique avec le circuit intégré et d'un condensateur (12) placé en contact thermique avec l'enceinte étanche, le réservoir (9) et le condenseur (12) étant reliés entre eux par un conducteur thermique creux (11) à l'intérieur duquel circule un corps réfrigérant.

Application : dispositif de refroidissement de composants électroniques.

Fig.1

Dispositif de refroidissement de circuits intégrés à semiconducteur.

La présente invention concerne un dispositif de refroidissement de circuits intégrés à semiconducteur.

La haute intégration des circuits intégrés et leur assemblage sur des cartes de circuits imprimés à l'intérieur d'espaces de plus en plus réduits posent le problème de leur refroidissement.

Des dispositifs de ventilation par air permettent encore dans beaucoup d'applications de résoudre ce problème mais ces dispositifs sont inapplicables aux réalisations dans lesquelles les cartes de circuits intégrés sont maintenues enfermées à l'intérieur d'enceintes étanches. Dans ce dernier cas les calories internes à une enceinte sont évacuées soit à l'aide de radiateurs recouvrant l'enveloppe externe de l'enceinte, soit encore à l'aide de capsules de refroidissement à effet Pelletier. Ces solutions présentent les inconvénients d'être encombrantes et onéreuses. Les radiateurs et les capsules de refroidissement à effet Pelletier augmentent en effet dans des proportions non négligeables les dimensions externes des enceintes et dans certaines conditions climatiques très particulières où le milieu dans lequel est plongé l'enceinte présente des fluctuations de température importantes comprises par exemple entre -55° et +125°, les solutions connues imposent le choix de circuits intégrés très performants, satisfaisant à des normes d'homologation très sévères, du type par exemple de celles fixées pour les applications militaires, ce qui conduit à des réalisations chères, alors qu'avec des moyens de refroidissement plus efficaces les mêmes fonctionnalités au plan électrique et électronique pourraient être réalisées par des composants de prix très peu élevés mais fonctionnant dans des gammes de température plus étroites. D'autre part, les solutions de refroidissement connues permettent d'obtenir un abaissement global de la température interne d'enceintes étanches sans laisser pour autant la possibilité d'agir de façon sélective sur la température de certains circuits intégrés des cartes de l'enceinte dont le gradient de température est particulièrement élevé, de sorte que, dans ces types de réalisations chaque circuit intégré contribue à l'échauffement des circuits intégrés voisins où est réchauffé par ses voisins ce qui rend encore plus critique les plages de fonctionnement acceptables. Le but de l'invention est de pallier les inconvénients précités.

A cet effet, l'invention a pour objet, un dispositif de refroidissement de circuits intégrés à semiconducteur placé sur un substrat isolant à l'intérieur d'une enceinte étanche ou tout autre dispositif de référence de température bonne conductrice de la chaleur caractérisé en ce qu'il établit un pont thermique entre chaque circuit intégré à refroidir et l'enceinte étanche à l'aide d'un dispositif caloduc composé d'un réservoir d'évaporation placé en contact thermique avec le circuit intégré et d'un condenseur placé en contact thermique avec l'enceinte étanche, le réservoir et le condenseur étant reliés entre eux par un conducteur thermique creux à l'intérieur duquel, circule un corps réfrigérant.

L'invention sera mieux comprise et d'autres caractéristiques apparaîtront à l'aide de la description qui suit en référence aux figures annexées et qui représentent :

La figure 1, une vue en coupe du dispositif de refroidissement d'un circuit intégré à semiconducteur selon l'invention;

La figure 2, une vue en perspective du dispositif représenté à la figure 1.

La figure 3, un mode de réalisation d'un raccordement thermique entre un circuit intégré et une enceinte selon l'art connu;

Les figures 4A et 4B, les schémas thermiques équivalents du dispositif représenté à la figure 3;

La figure 5, un mode de réalisation d'un raccordement thermique d'un circuit intégré à son enceinte à l'aide du dispositif selon l'invention;

Les figures 6A et 6B, les schémas thermiques équivalents correspondant au mode de réalisation selon l'invention représentée à la figure 5;

La figure 7, une variante de réalisation du dispositif de refroidissement selon l'invention.

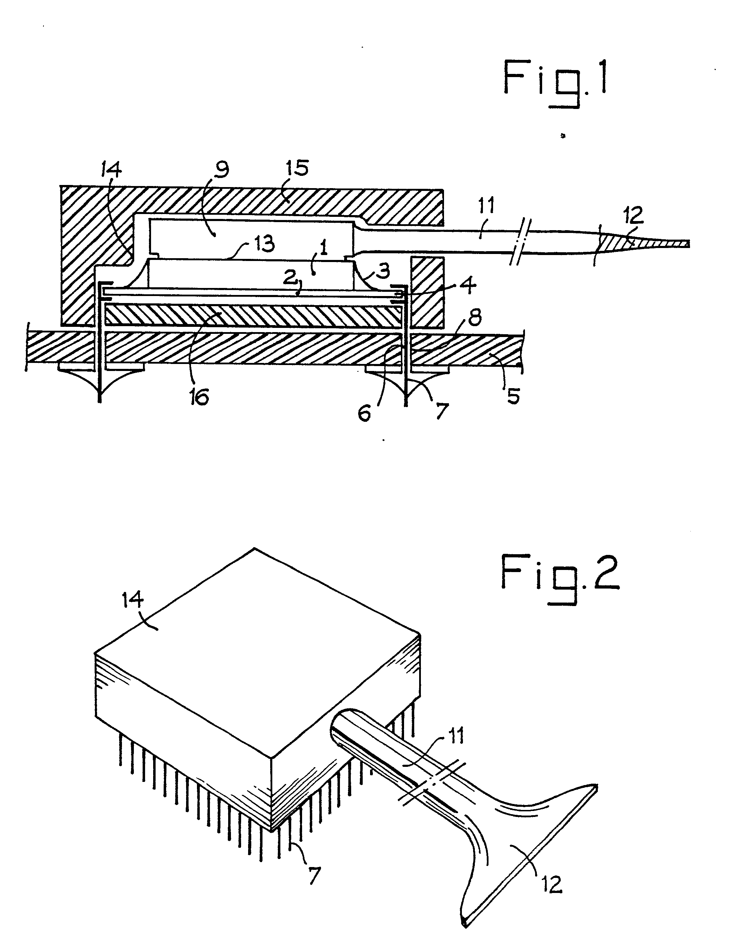

Un exemple de réalisation du dispositif de refroidissement d'un circuit intégré selon l'invention est décrit ci-après à l'aide de la figure 1. Sur la figure 1, le circuit intégré 1 à refroidir est monté sur un substrat 2 en verre époxy ou tout matériau équivalent mauvais conducteur de la chaleur, et est maintenu sur ce substrat par des broches de liaisons 3 qui sont soudées par leur extrémité libre à des contacts de liaison 4 répartis à la périphérie du substrat 2. Le circuit intégré 1 et son substrat 2 sont fixés sur une plaque de circuits imprimés 5 en verre époxy ou tout autre matériau équivalent mauvais conducteur de la chaleur, à l'aide de broches de liaison 6 soudées par une de leurs extrémités aux plages de contact 3 et par leurs autres extrémités à des plages de contact 7 du circuit imprimé 5. Sur la figure 1, les broches de contact 6 traversent l'épaisseur du circuit imprimé 5 au travers de trous métallisés 8. Un dispositif de refroidissement de types caloduc composé d'un réservoir d'évaporation 9, et d'un condenseur 12 reliés entre eux par un conducteur thermique creux 11 à l'intérieur duquel circule un corps réfrigérant du type eau ou d'un corps réfrigérant connu sous la marque fréon, dans les états de liquide ou de vapeur, ou tout corps réfrigérant équivalents, assure l'évacuation des calories dissipées par le circuit intégré 1 vers le condenseur 12. L'évacuation des calories est assurée par la mise en contact du réservoir d'évaporation 9 sur la surface 13 du circuit intégré 1 opposée à celle de la face qui est en contact avec le substrat 2. Pour éviter des échanges thermiques entre le circuit intégré 1 et les autres circuits intégrés voisins, non représentés, et disposés sur la plaque de circuit imprimé 5, le circuit intégré 1 et le substrat 2 sont encapsulés à l'intérieur d'un boîtier 14 formé d'un couvercle 15 et d'un fond 16. Le fond 16 est interposé entre le substrat 2 et la plaque de circuit imprimé 5 et le boîtier 15 recouvre l'ensemble formé par le circuit intégré 1, le réservoir 9 et le fond 16.

Une représentation en perspective du dispositif de refroidissement selon l'invention est montrée à la figure 2, cette représentation fait apparaître l'extrémité du conducteur thermique 11 formant le condenseur 12 qui est évasée pour permettre la condensation du corps réfrigérant transitant dans le tube 11 en arrivant sur la zone froide du condenseur 12.

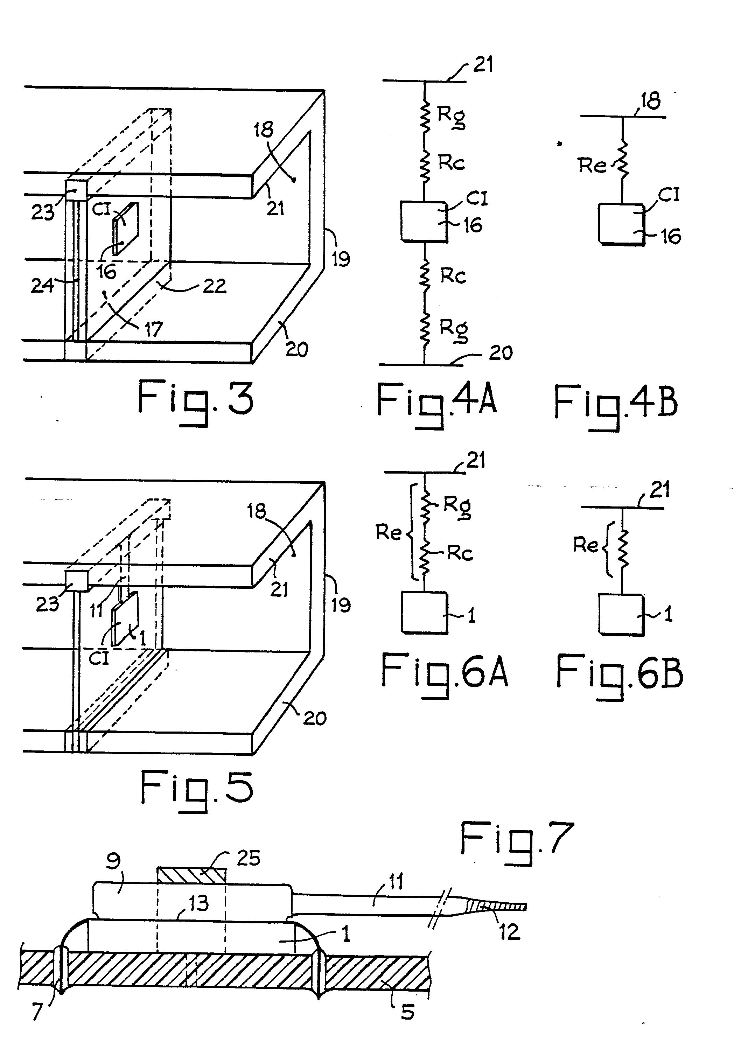

Comparé aux dispositifs de refroidissement de l'art connu du type de celui qui est représenté à la figure 3, le dispositif selon l'invention permet d'obtenir des résistances thermiques très faibles entre le circuit intégré et les faces de l'enceinte renfermant le circuit intégré. Dans l'exemple représenté à la figure 3, un circuit intégré 16 est figuré monté sur une plaque de circuit imprimé 17, à l'intérieur d'un caisson métallique étanche 18 dont seulement une partie du chassis en forme de U, 19 a été représentée. Les faces latérales 20 et 21 en vis-à-vis, du chassis 19 supportent des glissières 22 et 23 pour supporter la plaque 17. La plaque de circuit imprimé 17 comporte une plaque en cuivre 24 qui est mise en contact thermique avec les faces latérales 20 et 21 du chassis par l'intermédiaire des glissières 22 et 23. L'évacuation des calories engendrées par le circuit intégré s'effectue par l'intermédiaire de la plaque de cuivre et des deux contacts thermiques réalisés par les glissières 22 et 23. La résistance thermique $R_c$ de la plaque de cuivre 24 et celle des contacts $R_g$ de chaque glissière sont en série sur chacun des trajets situés sur la plaque de cuivre 27 entre le circuit intégré 16 et chacune des faces latérales 20 ou 21 du chassis. L'agencement de ces résistances sur ces deux trajets est représenté à la figure 4A, et ces résistances présentent des valeurs qui dans les réalisations courantes sont à peu près égales à 2° centigrade par watt pour la résistance de contact $R_g$ assurée par une glissière et 16° centigrade par watt pour celle $R_c$ d'un trajet sur la plaque de cuivre. L'ensemble des deux trajets peut être réduit en un seul trajet équivalent de résistance thermique $R_e$ = 9° centigrade par watt, équivalente à la résultante des résistances de chacun des deux trajets mises en parallèle.

A la différence avec le schéma représenté à la figure 3, le dispositif selon l'invention qui est représentée sur la figure 5 monté à l'intérieur de la même enceinte 18 à la place de la plaque 17 de la figure 3 n'offre qu'un seul trajet pour évacuer les calories entre le circuit intégré 1 et une glissière 23 de l'enceinte 18. Ce trajet présente une résistance thermique $R_e$ qui est égale comme le montre les figures 6A et 6B à l'addition des résistances $R_c$ du dispositif de refroidissement à caloduc selon l'invention et de la résistance $R_g$ de contact représentée par le guide 23, mais la résistance $R_c$ est dans ce mode de réalisation voisine de 0,1° centigrade par watt ce qui paraît par conséquent très faible par rapport à la résistance de contact $R_g$. Par conséquent le dispositif selon l'invention opposé au dispositif de l'art antérieur représenté à la figure 3 réduit fortement la résistance thermique existante entre le circuit intégré et l'enceinte dans un rapport de 9 à 2. En se plaçant par exemple dans des conditions pratiques d'exploitation où pour une puissance dissipée à l'intérieur d'une enceinte de l'ordre de 200 watts la température extérieure des faces de l'enceinte est égale à environ à 80°C, ce qui correspond à peu près à ce qui peut être obtenu avec une enceinte ayant la forme d'un caisson rectangulaire de dimension à peu près égale à 32x26x20cm, un circuit intégré dissipant 2 watts est porté dans l'exemple de la figure 3 à une température de 80 + 2 x 9 = 98°C alors que lorsqu'il est refroidi par le dispositif montré à la figure 5, sa température est de 80° + 2 x 2 = 84°C.

L'exemple qui vient d'être donné d'un mode particulier de réalisation de l'invention n'est pas unique, il va de soi que d'autres modes de réalisation sont également possibles. En particulier, il est possible de concevoir des modes de réalisation du type de celui qui est représenté à la figure 7 dans certains cas où il n'est pas nécessaire d'isoler thermiquement le circuit intégré des composants voisins placés sur la plaque de circuit imprimé et sur les plaques voisines à l'intérieur de l'enceinte. Dans de nombreuses applications, la résistance thermique couplant le circuit intégré à un élément voisin restera en effet relativement élevée vis-à-vis de la résistance thermique du dispositif de refroidissement à caloduc de l'invention et par conséquent son action restera négligeable. On veillera cependant, dans ces cas, à remplacer le boîtier 14 de la figure 1 par un dispositif de fixation formé par un collier de serrage 25 ou tous dispositifs équivalents, pour maintenir le réservoir d'évaporation contre la face extérieure des circuits intégrés de manière à assurer un bon échange thermique entre le circuit intégré et le réservoir d'évaporation.

**Revendications**

1. Dispositif de refroidissement de circuits intégrés (1) à semiconducteur placé sur un substrat isolant (2,5) à l'intérieur d'une enceinte étanche (18) bonne conductrice de la chaleur, caractérisé en ce qu'il établit un pont thermique entre chaque circuit intégré (1) à refroidir et l'enceinte étanche (18) à l'aide d'un dispositif caloduc composé d'un réservoir d'évaporation (9) placé en contact thermique avec le circuit intégré et d'un condenseur (12) placé en contact thermique avec l'enceinte (18) étanche, le réservoir (9) et le condenseur (12) étant reliés entre eux par un conducteur thermique creux (11) à l'intérieur duquel circule un corps réfrigérant.

2. Dispositif selon la revendication 1, caractérisé en ce que le circuit intégré (1) et le réservoir d'évaporation (9) sont placés sur un circuit imprimé à l'intérieur d'une enceinte (14) en matériau non conducteur de la chaleur (5).

3. Dispositif selon l'une quelconque des revendications 1 et 2, caractérisé en ce que le corps réfrigérant est du fréon.

4. Dispositif selon l'une quelconque des revendications 1 et 2, caractérisé en ce que le corps réfrigérant est de l'eau.

5. Dispositif selon l'une quelconque des revendications 1 à 4, caractérisé en ce que l'extrémité du condenseur (12) est engagée à l'intérieur d'une glissière (21) de maintien du circuit imprimé à l'intérieur de l'enceinte (18), munie de contacts thermiques pour assurer la liaison thermique entre le conducteur thermique et les faces externes de l'enceinte (18).

6. Dispositif selon l'une quelconque des revendications 1 à 5, caractérisé en ce que le substrat isolant (2, 5) est en verre époxy.

7. Dispositif selon la revendication 2, caractérisé en ce que le circuit imprimé comporte un substrat en verre époxy.

Fig.1

Fig.2

0 192 541

Fig.3

Fig.4A

Fig.4B

Fig.5

Fig.6A

Fig.6B

Fig.7

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | GB-A-1 563 091 (REDPOINT) <br> * Figure 4; revendications 1,4 * | 1 | H 01 L 23/42 |
| Y | GB-A-1 455 002 (REDPOINT) <br> * Figure 3; revendication 1 * | 1,2 | |
| A | FR-A-2 292 335 (SUNDSTRAND) <br> * Revendications 1,2,5 * | 1-3 | |
| A | FR-A-2 341 202 (SONY) <br> * Revendications 1,3; page 4, ligne 38 - page 5, ligne 2 * | 1,2,4 | |
| A | GB-A-2 039 416 (NIPPON TELEGRAPH & TELEPHONE) <br> * Revendications 1,7 * | 1,3,4 | DOMAINES TECHNIQUES RECHERCHES (Int. Cl.4) |
| A | FR-A-2 438 339 (SOC. SUISSE) <br> * Page 2, lignes 32-34 * | 6,7 | H 01 L |

Le présent rapport de recherche a été établi pour toutes les revendications

| Lieu de la recherche <br> LA HAYE | Date d'achèvement de la recherche <br> 15-05-1986 | Examinateur <br> DE RAEVE R.A.L. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou apres cette date
D : cité dans la demande
L : cité pour d'autres raisons
& : membre de la même famille, document correspondant

OEB Form 1503 03 82